# EUROPEAN PATENT SPECIFICATION

(11) **EP 3 736 127 B1**
(45) Date of publication and mention of the grant of the patent: **11.05.2022**
(21) Application number: 18902890.5
(22) Date of filing: 02.04.2018
(51) Int. Cl.: B32B 17/10, B32B 1/00

(54) **METHOD FOR MANUFACTURING CURVED LAMINATED GLASS**
VERFAHREN ZUR HERSTELLUNG VON GEKRÜMMTEM VERBUNDGLAS
PROCÉDÉ DE PRODUCTION DE VERRE FEUILLETÉ INCURVÉ

(30) Priority: 25.01.2018 CN 201810072865
(43) Date of publication of application: 11.11.2020
(73) Proprietor: Changzhou Almaden Co., Ltd., Changzhou, Jiangsu 213000 (CN)
(72) Inventor: LIN, Jinhan, Changzhou, Jiangsu 213000 (CN); YU, Liming, Changzhou, Jiangsu 213000 (CN)
(74) Representative: Zaboliene, Reda
(86) International application number: PCT/CN2018/081597
(87) International publication number: WO 2019/144500

(56) References cited:
- WO-A1-2017/155932
- CN-A- 1 805 849
- CN-A- 101 684 032
- CN-A- 101 684 032
- CN-A- 102 759 765
- DE-A1- 19 519 504
- DE-A1-102008 031 770
- US-A1- 2016 207 290

## Description

### TECHNICAL FIELD

The present application relates to the technical field of glass, and particularly to a manufacturing method for laminated curved glass.

### BACKGROUND

High light transmittance and excellent physical and chemical stability of glass determine its irreplaceable and important position in the fields of construction, vehicles, new energy etc.. Toughening and lamination are common glass processing techniques that increase the safety of glass (such as wind load resistance, fall protection, bulletproof, etc.). In some special cases, in order to achieve special design goals, some double curved toughened and laminated glass products, such as the windshield of automobiles, are indispensable The prior technology, such as a patent with the publication number CN105960384A, usually obtain a laminated curved glass by following steps: heating an ordinary flat glass to the glass softening temperature, then obtaining a curved glass by gravity molding or pressure molding, and then laminating the curved glass and an adhesive film, heating the adhesive film to a temperature that the adhesive film can be softened for gluing, thereby obtaining the laminated curved glass.

Because the above curved glass is formed at the glass softening temperature, so the glass needs to be heated to about 700 degrees, this process takes a long time, and the energy consumption is high. At the same time, when gluing the curved glass, the pressure device contacts the glass surface just with some points, it is easy to cause uneven stress on the surface of the laminated curved glass, which may finally cause some defects, such as uneven mechanical properties, uneven glue strength, and regional optical distortion Alternative processes, in which a stack of two flat glass plates and an adhesive film is consolidated and simultaneously bent by low temperature molding, are disclosed in DE19519504A1, in DE102008031770A1, and in CN101684032A. A process for cold forming a laminated glazing into a complex shape is disclosed in WO2017155931A1.

### SUMMARY

This invention is to provide a manufacturing method for laminated curved glass as defined in claim 1. Preferred embodiments are defined in the dependent claims.

The beneficial effects of the present invention are as follows: the present invention provides a manufacturing method for laminated curved glass, firstly strengthening the first glass plate and the second glass plate, and then the first glass plate and the second glass plate or its prefabricated parts are pressed and molded to obtain the laminated curved glass under low pressure and low temperature, the laminated curved glass has advantages of high strength, no bubbles, good glue strength, low energy consumption and high processing efficiency.

### BRIEF DESCRIPTION OF THE DRAWINGS

The present invention will be further described with reference to the drawings and the cases.
Fig. 1 is a schematic view of a laminated curved glass of the present invention;
Fig. 2 is a cross-sectional view along line A-A of the laminated curved glass shown in FIG. 1; and
Fig. 3 is a schematic view of the press molding process of the laminated curved glass shown in FIG. 1.
In the Figs.: 10-laminated curved glass, 11 -first glass plate, 12-second glass plate, prefabricated part or bus roof prefabricated part, 13-adhesive film, 20-cold pressing device, 21-first mold, 22-second mold.

### DETAILED DESCRIPTION OF PREFERRED CASES

The present invention will now be described in detail with reference to the drawings. This figures are simplified schematic views and only illustrate the basic structure of the present invention in a schematic manner way, so they only show the configuration related to the present invention.

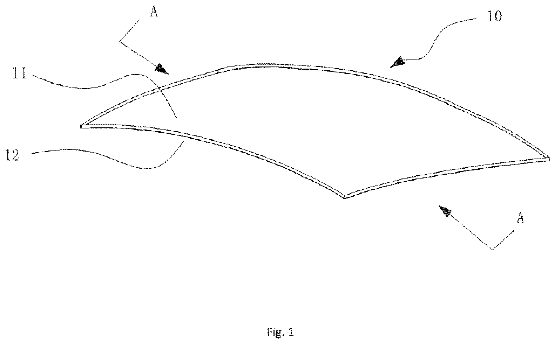

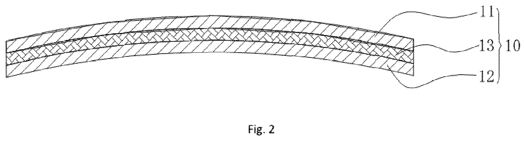

Referring to Figs. 1 and 2, the present invention provides a laminated curved glass 10. The laminated curved glass 10 includes a first glass plate 11, a second glass plate 12, and an adhesive film 13 configured between the first glass plate 11 and the second glass plate 12, and the thickness of the first glass plate 11 and the second glass plate 12 is 0.1 mm to 2.2 mm.

The first glass plate 11 or the second glass plate 12 may be float glass. Preferably, the first glass plate 11 or the second glass plate 12 is float glass with a thickness of 1.6 mm, and the ultra-white float glass contains 70.0-73% SiO₂ and 12.0-15.0% Na₂O.

The material of the adhesive film is PVB (Poly Vinyl Butyral), SGP (Ethylen/Methacrylic Acid Copolymers), POE (polyolefin elastomer) or PO (polyolefin ) and other hot melt adhesive materials.

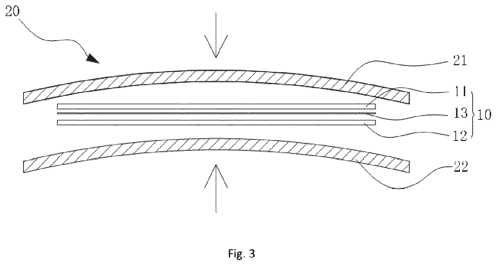

Please refer to FIG. 3 meanwhile, the manufacturing process of the laminated curved glass 10 shown in FIG. 1 includes the following steps:
(1) Providing the first glass plate 11 and the second glass plate 12 with a thickness of 0.1 mm to 2.2 mm, and the first glass plate 11 and the second glass plate 12 are flat sheet glasses;
(2) The first glass plate 11 of step (1) and the second glass plate 12 of step (1) are processed with strengthening treatment, in this case, a flat plate strengthening treatment is processed, it can minimize damage or uneven heating of the glass caused by the contact of the glass with the transmission device or the heating device.The first glass plate 11 and the second glass plate 12 are strengthened in the shape of a flat plate. After the treatment, the first glass plate 11 or the second glass plate 12 is still in the shape of a flat plate. The surface stress of the first glass plate 11 or the second glass plate 12 is controlled within the range of 10-1000MPa, and the flatness of the first glass plate 11 or the second glass plate 12 is less than 5‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. Under conditions of vacuum pressure, the first mold 21 or the second mold 22 is heated to 80°C to 380°C, then the adhesive film 13 is melted, and then the first glass plate 11 and the second glass plate 12 are pressed respectively by the first mold 21 and the second mold 22 at a pressure of 10-100 kPa, so that the first glass plate 11 is gradually attached to the concave surface of the first mold 21, and the second glass plate 12 is gradually attached to the convex surface of the second mold 22, and maintain this state for 600s to 2400s, the laminated curved glass 10 is finally manufactured.

It can be understood that the above step (1) may further include cutting the first glass plate 11 and the second glass plate 12 to the desired size, and some other processes such as edging and cleaning.

It can be understood that the first mold 21 and the second mold 22 may be heated at the same time or separately, as long as the adhesive film 13 can be softened.

The strengthening treatment in the above step (2) may be physical strengthening, that is, by heating the first glass plate 11 and the second glass plate 12 to the glass softening temperature, and maintaining for a while, and then cooling. It can be understood that the first glass plate 11 and the second glass plate 12 may also be chemical strengthening, and the chemical strengthening treatment may be a high temperature ion exchange method or a low temperature ion exchange method. For example, for the high temperature ion exchange method, during a temperature range between the softening point and the transition point of the glass, the glass containing Na₂O is immersed into a molten salt containing lithium, then Na⁺ in the glass is exchanged with Li⁺ in the molten salt, which has a smaller radius, and then cooled to room temperature. Because the expansion coefficient of the surface layer of the glass containing Li⁺ is different from the inner layer of glass containing Na⁺ or K⁺, the residual pressure on the glass surface strengthens the glass and increases its strength.

For the low temperature ion exchange method, during a temperature range not higher than the glass transition point, the glass is immersed in a molten salt containing an alkali ion having a larger radius than the alkali ions in the glass. For example, replace Na+ with K+ and then cool. A surface compressive stress layer is formed due to the volume difference of the alkali ions, which increases the strength of the glass. Although the exchange rate is slower than the high temperature ion exchange method, it has practical value because the glass is not deformed during tempering.

This case uses the low temperature ion exchange method. The first glass plate 11 and the second glass plate 12 are heated for 1 h ~ 3 h, and the temperature thereof is raised to 300°C to 450°C. After heating to the desired temperature, the first glass plate 11 and the second glass plate 12 are placed in a potassium nitrate solution or a mixed solution of potassium nitrate and sodium nitrate, the temperature of the solution is 400°C to 450°C, and maintain for 240 min to 600 min, and then let it cool to 5°C ~ 50°C.

The composition of the molten salt solution can be adjusted according to the composition of the glass.
(1) Providing the first glass plate 11 and the second glass plate 12 with a thickness of 1.6 mm. The first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 or the second glass plate 12 is 75MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 540s to a vacuum pressure of 30Pa, the first mold 21 is not heated, the second mold 22 is heated to 120°C, then the adhesive film 13 is melted, and then the first glass plate 11 and the second glass plate 12 are pressed respectively by the first mold 21 and the second mold 22 to a pressure of 90KPa, so that the first glass plate 11 is gradually attached to the concave surface of the first mold 21, and the second glass plate 12 is gradually attached to the convex surface of the second mold 22, and maintain this state for 1200s, the laminated curved glass 10 is finally manufactured. During the pressing process, vacuuming is continued, and bubbles in the melted adhesive film 13 are gradually discharged, and finally the laminated curved glass 10 is obtained.

### Case 2

(1) Providing the first glass plate 11 with a thickness of 1.6 mm and the second glass plate 12 with a thickness of 0.85 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 is 75MPa and the second glass plate 12 is 650MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 300s to a vacuum pressure of 50Pa, the first mold 21 is not heated, the second mold 22 is heated to 100°C, then the adhesive film 13 is melted, and then the first glass plate 11 and the second glass plate 12 are pressed respectively by the first mold 21 and the second mold 22 to a pressure of 80KPa, so that the first glass plate 11 is gradually attached to the concave surface of the first mold 21, and the second glass plate 12 is gradually attached to the convex surface of the second mold 22, and maintain this state for 1000s, the laminated curved glass 10 is finally manufactured. During the pressing process, vacuuming is continued, and bubbles in the melted adhesive film 13 are gradually discharged, and finally the laminated curved glass 10 is obtained.

### Case 3

(1) Providing the first glass plate 11 and the second glass plate 12 with a thickness of 2.2 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 and the second glass plate 12 is 20MPa, and the flatness thereof is less than 3‰*.*
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 720s to a vacuum pressure of 40Pa, the first mold 21 is not heated, the second mold 22 is heated to 180°C, then the adhesive film 13 is melted, and then the first glass plate 11 and the second glass plate 12 are pressed respectively by the first mold 21 and the second mold 22 to a pressure of 100KPa, so that the first glass plate 11 is gradually attached to the concave surface of the first mold 21, and the second glass plate 12 is gradually attached to the convex surface of the second mold 22, and maintain this state for 2400s, the laminated curved glass 10 is finally manufactured. During the pressing process, vacuuming is continued, and bubbles in the melted adhesive film 13 are gradually discharged, and finally the laminated curved glass 10 is obtained.

### Case 4

(1) Providing the first glass plate 11 with a thickness of 1.3 mm and the second glass plate 12 with a thickness of 0.7 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 is 550MPa and that of the second glass plate 12 is 750MPa, and the flatness thereof is less than 3‰.
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 1 1 and the convex surface of the second mold 22 faces the second glass plate 12. When vacuuming for 420s to a vacuum pressure of 40Pa, the first mold 21 is not heated, the second mold 22 is heated to 100°C, then the adhesive film 13 is melted, and then the first glass plate 11 and the second glass plate 12 are pressed respectively by the first mold 21 and the second mold 22 to a pressure of 60KPa, so that the first glass plate 11 is gradually attached to the concave surface of the first mold 21, and the second glass plate 12 is gradually attached to the convex surface of the second mold 22, and maintain this state for 800s, the laminated curved glass 10 is finally manufactured. During the pressing process, vacuuming is continued, and bubbles in the melted adhesive film 13 are gradually discharged, and finally the laminated curved glass 10 is obtained.

### Case 5

(1) Providing the first glass plate 11 with a thickness of 2.2 mm and the second glass plate 12 with a thickness of 0.1 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 is 20MPa and that of the second glass plate 12 is 900MPa, and the flatness thereof is less than 3‰*.*
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 420s to a vacuum pressure of 50Pa, the first mold 21 is heated to 80°C, the second mold 22 is heated to 80°C, then the adhesive film 13 is melted, and then the first glass plate 11 and the second glass plate 12 are pressed respectively by the first mold 21 and the second mold 22 to a pressure of 10KPa, so that the first glass plate 11 is gradually attached to the concave surface of the first mold 21, and the second glass plate 12 is gradually attached to the convex surface of the second mold 22, and maintain this state for 600s, the laminated curved glass 10 is finally manufactured. During the pressing process, vacuuming is continued, and bubbles in the melted adhesive film 13 are gradually discharged, and finally the laminated curved glass 10 is obtained.

### Comparative case

(1) Providing the first glass plate 11 and the second glass plate 12 with a thickness of 1.6 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.. In this step, the thickness and size of the first glass plate 11 and the second glass plate 12 as well as the edging, cleaning, etc. are the same as those in the first case.
(2) Pre-pressing process: the first glass plate 11 processed in step (1), the adhesive film 13 and the second glass plate 12 processed in step (1) are laminated in sequence to form a laminate, and then the laminate is placed in a vacuum bag made of rubber, and be kept at 60°C for 30 minutes and then at 100°C for 60 minutes.
(3) The pre-pressed laminate is placed in an autoclave, and heated at 140°C and 1.3 MPa for 30 minutes, and finally the laminated curved glass 10 is obtained.

In order to evaluate the performance of the laminated curved glass 10 of the cases 1-5 and the comparative case of the present invention, the following tests are conducted.

Stress test: Perform stress test on the sample by a surface stress meter. Let the light propagate along the glass surface, and measure the stress on the surface of the sample and the depth of the stress layer according to the photoelastic technology. Take more than five test points for each sample.

Transmittance test: Test the transmittance of the sample by a spectrophotometer, and the test wavelength range is 380nm to 1100nm.

Bending depth test: Scan the sample to test the bending depth by a three-dimensional scanner.

Gluing performance test: Detect whether the sample has bubbles or bad gluing area by AOI automatic optical detector.

Test Results:

| Sample | Case 1 | Case 2 | Case 3 | Case 4 | Case 5 | Comparative case |
|---|---|---|---|---|---|---|
| Stress value | 75MPa | 750MPa | 20MPa | 7500MPa | 950MPa | Less than 10MPa |
| Transmittance | 85.39% | 85.83% | 85.07% | 85.87% | 86.11% | 85.19% |
| Gluing performance | No bubbles, good gluing | No bubbles, good gluing | No bubbles, good gluing | No bubbles, good gluing | No bubbles, good gluing | No bubbles, good gluing |
| Penetration resistance | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample | 2260g steel ball impacts the sample at a height of 4 meters, the steel ball does not penetrate the sample |
| Human head | A 10kg human | A 10kg human | A 10kg human | A 10kg human | A 10kg human | A 10kg human head |
| simulation test | head model impacts the center point of the sample at a height of 1.5 meters, the sample is destroyed, the human head model does not penetrate the sample, and no fragments peels off | head model impacts the center point of the sample at a height of 1.5 meters, the sample is destroyed, the human head model does not penetrate the sample, and a small amount of small fragments peels off | head model impacts the center point of the sample at a height of 1.5 meters, the sample is destroyed, the human head model does not penetrate the sample, and no fragments peels off | head model impacts the center point of the sample at a height of 1.5 meters, the sample is destroyed, the human head model does not penetrate the sample, and no fragments peels off | head model impacts the center point of the sample at a height of 1.5 meters, the sample is destroyed, the human head model does not penetrate the sample, and no fragments peels off | model impacts the center point of the sample at a height of 1.5 meters, the sample is destroyed, the human head model does not penetrate the sample, and no fragments peels off |
| Energy consumption test | 70 seconds under high temperature | 45 seconds under high temperature | 85 seconds under high temperature | 75 seconds under high temperature | 40 seconds under high temperature | more than 600 seconds under high temperature |

From the above test results, it can be seen that the laminated curved glass prepared by the present invention has achieved excellent test results such as stress value, transmittance, gluing performance, penetration resistance, bending depth, and human head simulation test. The test results can meet the requirements of the automotive field. Compared with the comparative case, the cases 1-5 of the present invention have obvious advantages in stress value, and may greatly reduce the energy consumption, save the processing time, and improve the production efficiency.

### Case 6: Panoramic roof glass

(1) Providing the first glass plate 11 and the second glass plate 12 with a thickness of 1.6 mm, the first glass plate 11 and the second glass plate 12 are flat sheet glasses, and the sheet glasses are float glasses. The first glass plate 11 and the second glass plate 12 are cut to the desired size, and processed by edging, cleaning, etc.;
(2) The first glass plate 11 of step (1) and the second glass plate 12 of step (1) are processed with strengthening treatment. After the treatment, the surface stress of the first glass plate 11 and the second glass plate 12 is 75MPa, and the flatness thereof is less than 3‰*.*
(3) Molding process, the first glass plate 11 strengthened in step (2), the adhesive film 13 and the second glass plate 12 strengthened in step (2) are laminated in sequence and placed in a cold pressing device 20, moreover, the concave surface of the first mold 21 faces the first glass plate 11 and the convex surface of the second mold 22 faces the second glass plate 12. When vacuuming for 540s to a vacuum pressure of 30Pa, the first mold 21 is not heated, the second mold 22 is heated to 120°C, then the adhesive film 13 is melted, and then the first glass plate 11 and the second glass plate 12 are pressed respectively by the first mold 21 and the second mold 22 to a pressure of 90KPa, so that the first glass plate 11 is gradually attached to the concave surface of the first mold 21, and the second glass plate 12 is gradually attached to the convex surface of the second mold 22, and then maintain this state for 1200s, the laminated curved glass 10 is finally manufactured. During the pressing process, vacuuming is continued, and bubbles in the melted adhesive film 13 are gradually discharged, and finally the laminated curved glass 10 is obtained.
(4) Embed the glass products in the prefabricated frame of the panoramic roof glass and then fix it.

The above cases are embodiments of the present invention only, and should not be deemed as limitations to the scope of the present invention, which is as defined in the appended claims.

## Claims

1. A manufacturing method for laminated curved glass, wherein the laminated curved glass comprises a first glass plate, a second glass plate, and an adhesive film configured between the first glass plate and the second glass plate, the thickness of the first glass plate and the second glass plate is 0.1 mm to 2.2 mm, and the manufacturing method of the laminated curved glass comprised the following steps:
(1) providing the flat first glass plate and the flat second glass plate with a thickness of 0.1 mm to 2.2 mm;
(2) impose the first glass plate and the second glass plate with strengthening treatment, the processed first glass plate and the processed second glass plate are in the shape of a flat plate, and the surface stress of the first glass plate or the second glass plate is 10-1000MPa, the surface stress is tested by a surface stress meter, as further specified in the description; and
(3) low temperature molding process: providing the adhesive film, and laminating the first glass plate processed in step (2). the adhesive film, and the second glass plate processed in step (2) in sequence, and then performing the low temperature press molding process to obtain the laminated curved glass:
the low temperature molding process is performed in a cold pressing device, the cold pressing device comprises a first mold for molding the first glass plate into a curved shape and a second mold for molding the second glass plate into a curved shape, the heating temperature of the first mold or the second mold is 80 °C to 380 °C, the first glass plate is pressed by the first mold so that the first glass plate is attached to the concave surface of the first mold, and the second glass plate is pressed by the second mold so that the second glass plate is attached to the convex surface of the second mold.

2. The manufacturing method for laminated curved glass of claim **1**, wherein the step (3) is performed under vacuum conditions, the degree of vacuum ≤50Pa.

3. The manufacturing method for laminated curved glass of claim 1, wherein the laminated curved glass is a double curved glass.

4. The manufacturing method for laminated curved glass of claim 1, wherein at least one of the first mold and the second mold heats the first glass plate or the second glass plate.

5. The manufacturing method for laminated curved glass of claim **1,** wherein the maximum bending depth of the laminated curved glass is 180mm, the maximum bending depth is tested by a three-dimensional scanner.

6. The manufacturing method for laminated curved glass of claim **1,** wherein the adhesive film is made of hot melt adhesive material such as PVB, SGP, POE or PO, SGP is Ethylen/Methacrylic Acid Copolymers.

7. The manufacturing method for laminated curved glass of claim **1,** wherein, the pressure applied by the first mold to the first glass plate or the second mold to the second glass plate is 10-100 kPa.

## Patentansprüche

1. Herstellungsverfahren für gebogenes laminiertes Glas, wobei das gebogene laminierte Glas eine erste Glasplatte, eine zweite Glasplatte und eine zwischen der ersten Glasplatte und der zweiten Glasplatte konfigurierte Klebefolie umfasst, wobei die Dicke der ersten Glasplatte und der zweiten Glasplatte 0,1 mm bis 2,2 mm beträgt, und das Herstellungsverfahren für das gebogene laminierte Glas die folgenden Schritte umfasst:
(1) Bereitstellen der ersten flachen Glasplatte und der zweiten flachen Glasplatte mit einer Dicke von 0,1 mm bis 2,2 mm;
(2) Unterziehen der ersten Glasplatte und der zweiten Glasplatte einer Verstärkungsbehandlung, wobei die erste zu bearbeitende Glasplatte und die zweite zu bearbeitende Glasplatte Form einer flachen Platte haben und die Oberflächenbelastung der ersten Glasplatte oder der zweiten Glasplatte 10-1000 MPa beträgt, wobei die Oberflächenbelastung mit einem Oberflächenbelastungsmessgerät getestet wird, wie weiter in der Beschreibung angegeben;
und
(3) Niedrigtemperatur-Formverfahren, wobei:
die Klebefolie bereitgestellt wird und die in Schritt (2) verarbeitete erste Glasplatte, die Klebefolie und die in Schritt (2) verarbeitete zweite Glasplatte nacheinander laminiert werden und dann das Niedrigtemperatur-Pressformverfahren durchführt wird, um das gebogene laminierte Glas zu erhalten;
der Niedrigtemperatur-Formverfahren in einer Kaltpressvorrichtung durchgeführt wird, wobei die Kaltpressvorrichtung eine erste Form zum Formen der ersten Glasplatte in eine gebogene Form und eine zweite Form zum Formen der zweiten Glasplatte in eine gebogene Form umfasst, wobei die Heiztemperatur der ersten Form oder der zweiten Form 80°C bis 380°C beträgt, und die erste Glasplatte durch die erste Form so gepresst wird, dass die erste Glasplatte an der konkaven Oberfläche der ersten Form angelegt wird, und die zweite Glasplatte durch die zweite Form so gepresst wird, dass die zweite Glasplatte an der konkaven Oberfläche der zweiten Form angelegt wird.

2. Herstellungsverfahren für gebogenes laminiertes Glas nach Anspruch 1, wobei der Schritt (3) unter Vakuumbedingungen durchgeführt wird, wobei das Vakuumniveau ≤ 50 Pa ist.

3. Herstellungsverfahren für gebogenes laminiertes Glas nach Anspruch 1, wobei das gebogene laminierte Glas ein doppelt gebogenes Glas ist.

4. Herstellungsverfahren für gebogenes laminiertes Glas nach Anspruch 1, wobei entweder die erste Form oder die zweite Form die erste Glasplatte oder die zweite Glasplatte erhitzt.

5. Herstellungsverfahren für gebogenes laminiertes Glas nach Anspruch 1, wobei die maximale Biegetiefe des gebogenen laminierten Glases 180 mm beträgt, wobei die maximale Biegetiefe durch einen dreidimensionalen Scanner getestet wird.

6. Herstellungsverfahren für gebogenes laminiertes Glas nach Anspruch 1, wobei die Klebefolie aus Heißschmelzklebstoffmaterialien wie PVB [Polyvinylbutyral], SGP [Stufenwachstumspolymerisationen], POE [Polyolefin-Elastomere] oder PO [Polyolefine] hergestellt ist, wobei SGP [Stufenwachstumspolymerisationen] Ethylen/Methacrylsäure-Copolymere sind.

7. Herstellungsverfahren für gebogenes laminiertes Glas nach Anspruch 1, wobei der durch die erste Form auf die erste Glasplatte oder durch die zweite Form auf die zweite Glasplatte ausgeübte Druck 10-100 kPa beträgt.

## Revendications

1. Un procédé de fabrication de verre feuilleté bombé, dans lequel le verre feuilleté bombé comprend une première plaque de verre, une seconde plaque de verre, et un film adhésif configuré entre la première plaque de verre et la seconde plaque de verre, l'épaisseur de la première plaque de verre et de la deuxième plaque de verre est de 0,1 mm à 2,2 mm, et le procédé de fabrication du verre feuilleté bombé comprenait les étapes suivantes :
(1) doter la première plaque de verre plate et la seconde plaque de verre plate d'une épaisseur de 0,1 mm à 2,2 mm ;
(2) imposer un traitement de renforcement à la première plaque de verre et à la deuxième plaque de verre, la première plaque de verre traitée et la seconde plaque de verre traitée ont la forme d'une plaque plate, et la contrainte de surface de la première plaque de verre ou de la deuxième plaque de verre est de 10-1000MPa, la contrainte de surface est testée par un appareil de mesure de contrainte de surface, comme précisé plus en détail dans la description ;
et
(3) procédé de moulage à basse température :
fournir le film adhésif, et stratifier la première plaque de verre traitée à l'étape (2), le film adhésif, et la deuxième plaque de verre traitée à l'étape (2) en séquence, puis effectuer le processus de moulage sous pression à basse température pour obtenir le verre feuilleté bombé ;
le procédé de moulage à basse température est réalisé dans un dispositif de pressage à froid, le dispositif de pressage à froid comprend un premier moule pour mouler la première plaque de verre en une forme bombée et un deuxième moule pour mouler la deuxième plaque de verre en une forme bombée, la température de chauffage du premier moule ou du second moule est de 80°C à 380°C, la première plaque de verre est pressée par le premier moule de sorte que la première plaque de verre soit fixée à la surface concave du premier moule, et la deuxième plaque de verre est pressée par le deuxième moule de sorte que la deuxième plaque de verre soit fixée à la surface convexe du deuxième moule.

2. Le procédé de fabrication de verre feuilleté bombé selon la revendication 1, dans laquelle l'étape (3) est réalisée dans des conditions de vide, le degré de vide ≤ 50 Pa.

3. Le procédé de fabrication de verre feuilleté bombé selon la revendication 1, dans laquelle le verre feuilleté bombé est un verre bombé double.

4. Le procédé de fabrication de verre feuilleté bombé selon la revendication 1, dans laquelle au moins l'un parmi le premier moule et le second moule chauffe la première plaque de verre ou la seconde plaque de verre.

5. Le procédé de fabrication de verre bombé feuilleté selon la revendication 1, dans laquelle la profondeur de courbure maximale du verre feuilleté bombé est de 180 mm, la profondeur de courbure maximale est testée par un scanner tridimensionnel.

6. Le procédé de fabrication de verre feuilleté bombé selon la revendication 1, dans laquelle le film adhésif est constitué d'un matériau adhésif thermofusible tel que le PVB, SGP, POE ou PO, SGP est un copolymère éthylène/acide méthacrylique.

7. Le procédé de fabrication de verre feuilleté bombé selon la revendication 1, dans laquelle la pression appliquée par le premier moule à la première plaque de verre ou le second moule à la seconde plaque de verre est de 10 à 100 kPa.
